# EUROPEAN PATENT APPLICATION

(11) **EP 4 822 744 A1**
(43) Date of publication of application: **14.10.2026**
(21) Application number: 24900674.3
(22) Date of filing: 05.12.2024
(51) Int. Cl.: H01L 23/36, H05K 7/20

(54) **RESIN SHEET AND METHOD FOR MANUFACTURING SAME**

(30) Priority: 08.12.2023 JP 2023207451
(71) Applicant: Mitsubishi Chemical Corporation, Tokyo 100-8251 (JP)
(72) Inventor: KOGA, Yuya, Tokyo 100-8251 (JP); WATANABE, Akira, Tokyo 100-8251 (JP); TANAKA, Toshiyuki, Tokyo 100-8251 (JP); KOSUGI, Yuko, Tokyo 100-8251 (JP); INAKOSHI, Akane, Tokyo 100-8251 (JP); YAGISHITA, Kaoru, Tokyo 100-8251 (JP)
(74) Representative: Hoffmann Eitle
(86) International application number: PCT/JP2024/043080
(87) International publication number: WO 2025/121381

(57) **Abstract**

There is provided a resin sheet containing a filler formed by aggregation of primary particles having a plate shape, a scale shape, or a needle shape, wherein thermal conductivity of the resin sheet can be increased. The resin sheet is characterized in that a ratio (Pi/Po) of a peak area intensity ratio Pi ((002)/(100)) to a peak area intensity ratio Po ((002)/(100)) is 0.13 or more and 0.41 or less, the peak area intensity ratio Pi ((002)/(100)) being a peak area intensity ratio between a (002) plane of the filler and a (100) plane of the filler in the resin sheet, the peak area intensity ratio Pi being obtained by measuring the resin sheet using an In-Plane X-ray diffraction method, the peak area intensity ratio Po ((002)/(100)) being a peak area intensity ratio between the (002) plane of the filler and the (100) plane of the filler in the resin sheet, and the peak area intensity ratio Po being obtained by measuring the resin sheet by an X-ray diffraction method using a focusing method. Alternatively, the resin sheet is characterized in that the peak area intensity ratio Pi ((002)/(100)) is 1.5 or more and 10.0 or less and the peak area intensity ratio Po ((002)/(100)) is 9.0 or more and 13.0 or less.

## Description

### Technical Field

The present invention relates to a resin sheet containing a filler, the resin sheet suitably usable as, for example, a heat dissipation member of a power semiconductor device, and a method for manufacturing the same.

### Background Art

Among devices using semiconductors, devices configured to control and convert electric power such as a power supply are called "power semiconductor devices".

The power semiconductor devices generally have a configuration in which a power semiconductor configured to control and convert electric power and an electronic component are mounted on a substrate that functions as a heat sink.

In recent years, the power semiconductor devices used in various fields such as railway, automotive, and industrial and general household electric appliance applications are shifting from known Si power semiconductors to power semiconductors using, for example, SiC, AlN, and GaN, for the purpose of further size reduction, cost reduction, and efficiency improvement, for example.

Various problems have been pointed out for practical use of such power semiconductor devices, and one of the problems is heat generation from the devices. While the power semiconductor devices can achieve high output and high density when operated at high temperature, there has been a concern that heat generation caused by, for example. switching of the devices will lower reliability of the power semiconductor devices.

In recent years, in the electric and electronic fields, heat generation due to high density of integrated circuits has also become a serious problem. So, how to dissipate the heat has become an urgent problem. For example, when a semiconductor device used for controlling, for example, a central processing unit of a personal computer and a motor of an electric vehicle is stably operated, a heat sink, a heat dissipation fin, and the like are indispensable for heat dissipation. As a member for joining a member such as a circuit including a semiconductor and a heat dissipation member such as a heat sink, a member capable of achieving both thermal conductivity and insulation has been required.

As the member capable of achieving both thermal conductivity and insulation, a ceramic substrate having high thermal conductivity such as an alumina substrate or an aluminum nitride substrate has been used. However, the ceramic substrate has problems in that the ceramic substrate is easily broken by impact, and it is difficult to reduce the thickness and the size of the ceramic substrate, for example.

Hence, a heat dissipation sheet using a thermosetting resin such as an epoxy resin and a filler has been proposed.

As the heat dissipation sheet using a thermosetting resin and a filler, various resin sheets containing boron nitride as a filler have been proposed (see Patent Literatures 1 to 8).

Boron nitride is an insulating ceramic and has characteristics of having excellent thermal conductivity, solid lubricity, chemical stability, and heat resistance. Thus, boron nitride has been attracting attention in the field of electrical and electronic materials in recent years.

### Citation List

### Patent Literature

Patent Literature 1: JP 2015-006980 A
Patent Literature 2: JP 2015-189823 A
Patent Literature 3: JP 2015-195287 A
Patent Literature 4: JP 2016-011358 A
Patent Literature 5: JP 2016-135731 A
Patent Literature 6: JP 2019-119883 A
Patent Literature 7: JP 2021-006507 A

### Summary of Invention

### Technical Problem

Regarding the resin sheet containing a filler, when the filler is primary particles having a plate shape, a scale shape, or a needle shape, such as boron nitride particles, the filler has anisotropy in thermal conductivity. Thus, the thermal conductivity in a sheet surface direction tends to be high, while the thermal conductivity in a sheet thickness direction tends to be low. In addition, even when aggregate particles isotropically aggregated are used to avoid the tendencies, there has been a problem in that anisotropy occurs during the production of the sheet, and it is difficult to increase the thermal conductivity in the sheet thickness direction.

Accordingly, an object of the present invention is to provide a resin sheet containing a filler formed by aggregation of primary particles having a plate shape, a scale shape, or a needle shape, wherein thermal conductivity of the resin sheet can be increased, and a method for manufacturing the same.

### Solution to Problem

In order to solve the above problems, a resin sheet and a method for manufacturing the same proposed by the present invention have configurations as described below.
[1] A first aspect of the present invention is a resin sheet containing a filler formed by aggregation of primary particles having a plate shape, a scale shape or a needle shape,
   wherein a ratio (Pi/Po) of a peak area intensity ratio Pi ((002)/(100)) to a peak area intensity ratio Po ((002)/(100)) is 0.13 or more and 0.41 or less,
   the peak area intensity ratio Pi ((002)/(100)) being a peak area intensity ratio between a (002) plane of the filler and a (100) plane of the filler in the resin sheet, the peak area intensity ratio Pi being obtained by measuring the resin sheet by an In-Plane X-ray diffraction method,
   the peak area intensity ratio Po ((002)/(100)) being a peak area intensity ratio between the (002) plane of the filler and the (100) plane of the filler in the resin sheet, and the peak area intensity ratio Po being obtained by measuring the resin sheet by an X-ray diffraction method using a focusing method.
[2] A second aspect of the present invention is a resin sheet containing a filler formed by aggregation of primary particles having a plate shape, a scale shape or a needle shape, wherein
   a peak area intensity ratio Pi ((002)/(100)) between a (002) plane of the filler and a (100) plane of the filler in the resin sheet, the peak area intensity ratio Pi being obtained by measuring the resin sheet by an In-Plane X-ray diffraction method, is 1.5 or more and 10.0 or less, and
   a peak area intensity ratio Po ((002)/(100)) between the (002) plane of the filler and the (100) plane of the filler in the resin sheet, the peak area intensity ratio Po being obtained by measuring the resin sheet by an X-ray diffraction method using a focusing method, is 9.0 or more and 13.0 or less.
[3] A third aspect of the present invention is the resin sheet according to the first aspect, wherein the peak area intensity ratio Pi ((002)/(100)) is 1.5 or more and 10.0 or less.
[4] A fourth aspect of the present invention is the resin sheet according to the first or third aspect, wherein the peak area intensity ratio Po ((002)/(100)) is 9.0 or more and 13.0 or less.
[5] A fifth aspect of the present invention is the resin sheet according to any one of the first to fourth aspects, wherein the resin sheet is a cured product of a thermosetting resin composition containing the filler and a thermosetting resin.
[6] A sixth aspect of the present invention is the resin sheet according to the fifth aspect, wherein the thermosetting resin includes an epoxy resin.
[7] A seventh aspect of the present invention is the resin sheet according to any one of the first to sixth aspects, wherein the filler has a thermal conductivity of 10 W/m·k or more.
[8] An eighth aspect of the present invention is the resin sheet according to any one of the first to seventh aspects, wherein the filler contains boron nitride aggregate particles.
[9] A ninth aspect of the present invention is the resin sheet according to the eighth aspect, wherein the boron nitride aggregate particles have a card-house structure.
[10] A tenth aspect of the present invention is the resin sheet according to any one of the first to ninth aspects, wherein the resin sheet has a thermal conductivity of 10 W/m·K or more in a sheet thickness direction at 25°C.
[11] An eleventh aspect of the present invention is the resin sheet according to any one of the first to tenth aspects, wherein the resin sheet is used as a heat dissipation member of a power semiconductor device.
[12] A twelfth aspect of the present invention is a method for manufacturing the resin sheet described in any one of the first to eleventh aspects, the method including: molding the thermosetting resin composition containing the filler and the thermosetting resin into a coating film form or a sheet form; applying pressure to the thermosetting resin composition; and thermally curing the thermosetting resin composition.
[13] A thirteenth aspect of the present invention is the method for manufacturing the resin sheet according to the twelfth aspect, wherein the pressure application is performed by calender pressing under conditions of a linear pressure of 20 to 200 kgf/cm applied to the sheet and a roller temperature of 0 to 50°C, or by flat plate pressing under conditions of a pressure of 10 to 2000 kgf/cm² applied to the sheet, a metallic flat plate temperature of 0 to 100°C, and a pressure application time of 1 to 1500 seconds.
[14] A fourteenth aspect of the present invention is the method for manufacturing the resin sheet according to the twelfth or thirteenth aspect, wherein the thermal curing is performed by heating to 80 to 300°C and pressure application at a pressure of 50 to 2000 kgf/cm² for 0.5 to 240 minutes.
[15] A fifteenth aspect of the present invention is the method for manufacturing the resin sheet according to any one of the twelfth to fourteenth aspects, further including subjecting the thermosetting resin composition to low-temperature aging, the low-temperature aging including placing the thermosetting resin composition in a temperature environment of 0°C or lower.
[16] A sixteenth aspect of the present invention is the method for manufacturing the resin sheet according to the fifteenth aspect, wherein the low-temperature aging is performed after the molding the thermosetting resin composition into a coating film form or a sheet form and before the applying pressure to the thermosetting resin composition.

### Advantageous Effects of Invention

The resin sheet proposed by the present invention is a resin sheet having a controlled direction of orientation of the filler in the entire sheet, particularly in the vicinity of the sheet surface, the resin sheet capable of exhibiting excellent thermal conductivity, particularly thermal conductivity in the sheet thickness direction.

### Brief Description of Drawings

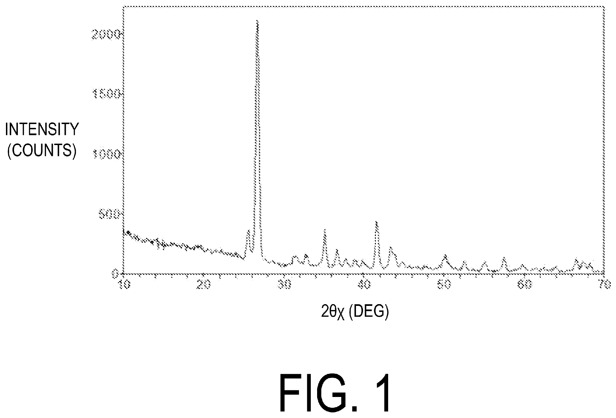

FIG. 1 is an X-ray diffraction profile diagram (XRD profile) obtained by measuring a resin sheet (sample) obtained in Example 1 by an In-Plane X-ray diffraction method.

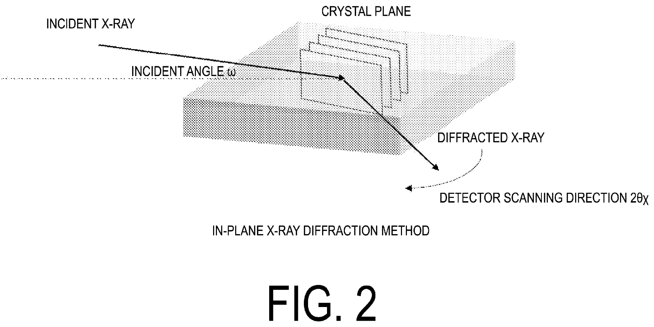

FIG. 2 is a schematic diagram illustrating the In-Plane X-ray diffraction method.

### Description of Embodiments

Hereinafter, an example of embodiments of the present invention will be described in detail. However, the present invention is not limited to the embodiments described below.

### Resin Sheet of Present Invention

A resin sheet according to an example of an embodiment of the present invention (also referred to as a "resin sheet of the present invention") is a resin sheet containing a filler formed by aggregation of primary particles having a plate shape, a scale shape, or a needle shape (also referred to as "the present filler").

An example of the resin sheet of the present invention can be a resin sheet formed of a cured product of a thermosetting resin composition containing the present filler and a thermosetting resin (also referred to as "the present thermosetting resin composition"). More specifically, examples of the resin sheet of the present invention include a sheet-shaped cured product formed by applying pressure to the thermosetting resin composition containing the present filler and a thermosetting resin, molding the thermosetting resin composition into a sheet form to yield a sheet-shaped product, and thermally curing the sheet-shaped product.

In the present invention, the "resin sheet" means a sheet having a synthetic resin as a component forming a continuous phase (matrix) of the sheet. The "synthetic resin" includes a thermoplastic resin, a thermosetting resin, and a cured product thereof, regardless of the molecular weight.

In the present invention, the term "resin" includes compounds, monomers, oligomers, and polymers, regardless of the molecular weight.

In the present invention, the "sheet surface direction" means a direction parallel to the sheet surface, and is also referred to as a "lateral direction". On the other hand, the "sheet thickness direction" means a film thickness direction of the sheet, and is also referred to as a "longitudinal direction".

### Present Filler

The present filler is formed of particles made of an organic substance or an inorganic substance, the particles being formed by aggregation of primary particles having a plate shape, a scale shape, or a needle shape, or an assembly of the particles. The present filler is preferably particles made of an inorganic substance (inorganic particles), the particles being formed by aggregation of primary particles having a plate shape, a scale shape, or a needle shape. The primary particles of the present filler exhibit anisotropy in thermal conductivity, and the present filler shows a tendency to be oriented in a specific direction in the resin sheet of the present invention. Thus, how the present filler is oriented in the resin sheet of the present invention has a significant influence on the thermal conductivity of the resin sheet of the present invention. Usually, at the time of sheet production, the primary particles of the filler are likely to be oriented in the sheet surface direction, and the thermal conductivity in the sheet thickness direction tends to be low. However, since the present filler is formed of aggregate particles, the primary particles in the particles are likely to be isotropically oriented as compared with non-aggregate particles. Thus, it can be said that the thermal conductivity in the sheet thickness direction shows a tendency to be increased.

The present filler preferably has a thermal conductivity of 10 W/m·K or more.

Examples of such a filler can include an electrically insulating filler composed only of carbon, and fillers composed of a metallic carbide or semi-metallic carbide, a metallic oxide or semi-metallic oxide, and a metallic nitride or semi-metallic nitride. One of the fillers may be used alone, or two or more thereof may be used in combination.

Examples of the electrically insulating filler composed only of carbon can include diamond (thermal conductivity: about 2000 W/m·K).

Examples of the metallic carbide or semi-metallic carbide can include silicon carbide (thermal conductivity: about from 60 to 270 W/m·K), titanium carbide (thermal conductivity: about 21 W/m·K), and tungsten carbide (thermal conductivity: about 120 W/m·K).

Examples of the metallic oxide or semi-metallic oxide can include magnesium oxide (thermal conductivity: about 40 W/m·K), zinc oxide (thermal conductivity: about 54 W/m·K), yttrium oxide (thermal conductivity: about 27 W/m·K), ytterbium oxide (thermal conductivity: about 38.5 W/m·K), beryllium oxide (thermal conductivity: about 250 W/m·K), and sialon (ceramic composed of silicon, aluminum, oxygen, and nitrogen, thermal conductivity: about 21 W/m·K).

Examples of the metallic nitride or semi-metallic nitride can include boron nitride (thermal conductivity in the sheet surface direction of plate-shaped particles of hexagonal boron nitride (h-BN): about 200 to 500 W/m·K), aluminum nitride (thermal conductivity: about 160 to 285 W/m·K), and silicon nitride (thermal conductivity: about 30 to 80 W/m·K).

A maximum particle size of the present filler is preferably 20 µm or more, more preferably 30 µm or more, and even more preferably 40 µm or more, since a relatively reduced number of particles in the resin sheet of the present invention leads to fewer inter-particle interfaces, and thus, the thermal resistance can be reduced and the thermal conductivity can be increased. Meanwhile, from the viewpoint of yielding surface smoothness of the resin sheet of the present invention, the maximum particle size is preferably 300 µm or less, more preferably 200 µm or less, and even more preferably 100 µm or less.

An average particle size of the present filler is preferably 5 µm or more, more preferably 10 µm or more, more preferably 15 µm or more, even more preferably 20 µm or more, still even more preferably 25 µm or more, and yet still even more preferably 30 µm or more, since a relatively reduced number of particles in the resin sheet of the present invention leads to fewer inter-particle interfaces, and thus, the thermal contact resistance can be reduced and the thermal conductivity can be increased. Meanwhile, from the viewpoint of yielding the surface smoothness of the resin sheet of the present invention, the average particle size is preferably 150 µm or less, more preferably 120 µm or less, and even more preferably 90 µm or less.

The maximum particle size and the average particle size of the present filler can be measured by, for example, the following method.

For a sample with the present filler dispersed in a solvent, specifically, a sample with the present filler dispersed in a pure water medium containing a dispersion stabilizer, the maximum particle size Dmax and the average particle size D50 of the present filler can be determined by measuring a volume-based particle size distribution using a laser diffraction/scattering particle size distribution analyzer, and identifying the maximum particle size Dmax and the average particle size D50 from the obtained particle size distribution.

Here, the Dmax and the D50 are the maximum particle size and the volume-based cumulative 50% particle size in a volume-based particle size distribution obtained by the measurement using a laser diffraction/scattering particle size distribution measurement method.

The maximum particle size and the average particle size can also be determined by a dry particle size distribution analyzer such as a Morphologi G3 (available from Malvern Instruments Ltd.).

Further, when the present filler is formed of inorganic particles, the resin sheet (cured product) of the present invention is fired and thus, resin components are removed. Thus, the present filler is separated. For example, an organic component of the resin sheet (cured product) of the present invention may be heated in the air, ashed, and removed, and Dmax and D50 of the present filler contained in the resulting ashed residue may be measured by laser diffraction or Morphologi.

In addition, it is possible to directly observe 10 or more of the present fillers randomly selected in a cross section of the resin sheet (cured product) of the present invention with, for example, a scanning electron microscope, a transmission electron microscope, a Micro-Raman spectrometer, and an atomic force microscope, and determine the maximum particle size among the present fillers, and to directly observe 10 or more of the present fillers randomly selected, and determine the average particle size by an arithmetic average value thereof.

When the particles of the present filler are non-spherical, the longest diameter and the shortest diameter of each particle are measured, and an average value of the longest diameter and the shortest diameter is set as the particle size of the particles.

A modulus of elasticity of the present filler is preferably 48 MPa or more, more preferably 50 MPa or more, and even more preferably 55 MPa or more, in view of the fact that plastic deformation in a direction of pressing pressure and collapse of an aggregate structure can be prevented. On the other hand, from the viewpoint of easily yielding sufficient deformation, the modulus of elasticity is preferably 1000 MPa or less, more preferably 500 MPa or less, and even more preferably 100 MPa or less.

A crushing strength of the present filler is preferably 4 MPa or more, and more preferably 5 MPa or more, and, on the other hand, is preferably 20 MPa or less, more preferably 15 MPa or less, and even more preferably 10 MPa or less. When the crushing strength is within such a range, it is possible to prevent the primary particles of the present filler from being excessively oriented in the sheet thickness direction after applying pressure, and the present fillers with the primary particles laid horizontally, in other words, oriented in the sheet surface direction, are present in an appropriate amount to an extent that the present fillers can be in surface contact with each other. Thus, a thermal conduction path is easily formed and the thermal conductivity is improved.

When the present filler is in the resin sheet of the present invention, the modulus of elasticity and the crushing strength of the present filler can be measured after the resin of the resin sheet of the present invention is burned off to take out the present filler, for the purpose of preventing alteration of the present filler. The measurement method is as described in Examples.

A content of the present filler is preferably 30 mass% or more, more preferably 40 mass% or more, and even more preferably 50 mass% or more, based on 100 mass% of the resin sheet of the present invention, from the viewpoint of enhancing the insulation and the thermal conductivity. On the other hand, from the viewpoint of maintaining good handleability (brittleness), the content is preferably 95 mass% or less, more preferably 90 mass% or less, and even more preferably 85 mass% or less.

### Boron Nitride Aggregate Particles

As the present filler, boron nitride aggregate particles formed by aggregation of boron nitride primary particles having a plate shape, a scale shape, or a needle shape are particularly preferable in terms of excellent insulation, thermal conductivity, solid lubricity, chemical stability, and heat resistance.

Examples of the boron nitride aggregate particles can include particles formed by spherical aggregation of the primary particles having a plate shape, a scale shape, or a needle shape.

The term "spherical" as used herein means that an aspect ratio (ratio between a major axis and a minor axis) is 1 or more and 2 or less, preferably 1 or more and 1.5 or less. The aspect ratio of the boron nitride aggregate particles is determined by randomly selecting 200 or more particles from an image taken with a scanning electron microscope, calculating, for each particle, the ratio between the major axis and the minor axis, and calculating the average value.

Examples of the boron nitride aggregate particles can include known particles such as particles having a form in which primary particles having a scale shape or an needle shape radially grow from a center side toward a surface side of each of the aggregate particles, particles having a spherical form with primary particles having a plate shape being sinter agglomerated, and particles having a card-house structure formed of primary particles having a plate shape. In particular, from the viewpoint of improving the thermal conductivity, the boron nitride aggregate particles preferably have a card-house structure.

As used herein, the "card-house structure" is a structure having plate-shaped particles laminated in a complex, non-oriented arrangement, as described in, for example, Ceramic 43 No. 2 (published by the Ceramic Society of Japan in 2008). More specifically, each of the boron nitride aggregate particles having a card-house structure is an assembly of boron nitride primary particles, and the boron nitride aggregate particles are boron nitride aggregate particles having a structure in which a plane portion and an end surface portion of the primary particles are in contact with each other.

### Additional Filler

The resin sheet of the present invention may contain an "additional filler" besides the present filler, that is, the filler formed by aggregation of the primary particles having a plate shape, a scale shape, or a needle shape.

The "additional filler" is preferably a filler having a thermal conductivity of 10 W/m·K or more. As an example, the additional filler is made of, for example, boron nitride, aluminum oxide (alumina), aluminum nitride, silica, and magnesium oxide. Examples of the additional filler can include aggregate particles formed by aggregation of primary particles having a shape other than a plate shape, a scale shape, and a needle shape, and non-aggregate particles.

When the "additional filler" is contained, alumina particles, particularly spherical alumina particles are preferably contained as the "additional filler", from the viewpoint of fillability, water resistance, and thermal conductivity.

An average particle size of the additional filler is preferably 0.5 µm or more, more preferably 1 µm or more, and even more preferably 3 µm or more, from the viewpoint of reducing thermal contact resistance between the fillers. Meanwhile, from the viewpoint of optimizing a filling rate, the average particle size is preferably 50 µm or less, more preferably 30 µm or less, and even more preferably 20 µm or less.

The average particle size of the additional filler can be measured by the same method as the method described for the average particle size of the present filler.

When the "additional filler" is contained, a content of all the fillers (the present filler and the additional filler) is preferably 40 mass% or more, more preferably 50 mass% or more, and even more preferably 60 mass% or more, based on 100 mass% of the resin sheet of the present invention, from the viewpoint of increasing the thermal conductivity. On the other hand, from the viewpoint of preventing a decrease in withstand voltage due to a reduced amount of the resin and from the viewpoint of the handleability of the resin sheet of the present invention, the content is preferably 95 mass% or less, more preferably 90 mass% or less, and even more preferably 85 mass% or less.

When the "additional filler" is contained, a mass proportion of the present filler in 100 mass% of all the fillers (the present filler and the additional filler) is preferably 50 mass% or more, more preferably 55 mass% or more, even more preferably 60 mass% or more, still even more preferably 65 mass% or more, and yet still even more preferably 70 mass% or more, from the viewpoint of increasing the thermal conductivity. On the other hand, the upper limit is not particularly limited, but needs only to be, for example, 99 mass% or less, and may be 98 mass% or less. Although the additional filler other than the present filler may not be contained, the filler can be more densely filled in some cases by incorporating the additional filler. In this case, the resin having a larger thermal resistance can be reduced, and the thermal conductivity can be increased.

### Resin

The resin in the resin sheet of the present invention is a matrix resin, that is, a component forming a continuous phase (matrix) of the resin sheet of the present invention, and is preferably a thermoplastic resin and/or a thermosetting resin. Especially, a thermosetting resin is preferred from the viewpoint of durability against heat, adhesiveness to metal, and handleability.

Examples of the thermoplastic resin of the resin sheet of the present invention can include a polyolefin resin, a polyester resin, a polycarbonate resin, a polystyrene resin, a polyvinyl alcohol resin, an acrylic resin, a polyurethane resin, a polyphenylene ether resin, a polysulfone resin, a polyphenylsulfone resin, a polyethersulfone resin, a polyetherimide resin, a polyamide resin, a polyetherketone-based resin, a polytetrafluoroethylene resin, a tetrafluoroethylene-perfluoroalkoxyethylene copolymer resin, and a tetrafluoroethylene-hexafluoropropylene copolymer resin.

The thermosetting resin of the resin sheet of the present invention needs only to be a compound (including a polymer) having a property of being cured by heat. Examples of the thermosetting resin can include an epoxy resin, a phenol resin, a polycarbonate resin, an unsaturated polyester resin, a urethane resin, a melamine resins, a urea resin, a maleimide resin, a cyanate resin, a benzoxazine, and a (meth)acrylic resin. Among these, from the viewpoint of viscosity, heat resistance, hygroscopicity, and handleability, an epoxy resin is preferably contained.

### Epoxy resin

The epoxy resin needs only to be a compound having one or more oxirane rings, that is, epoxy groups in the molecule.

The epoxy group contained in the epoxy resin may be either an alicyclic epoxy group or a glycidyl group. From the viewpoint of reaction rate or heat resistance, a glycidyl group is more preferable.

Examples of the epoxy resin can include an epoxy group-containing silicon resin, an aliphatic epoxy resin, a bisphenol A or F epoxy resin, a novolac epoxy resin, an alicyclic epoxy resin, a glycidyl ester epoxy resin, a polyfunctional epoxy resin, and a polymer epoxy resin.

The epoxy resin may be an aromatic epoxy group-containing resin. Specific examples of the aromatic epoxy group-containing resin can include bisphenol epoxy resins with bisphenols such as bisphenol A, bisphenol F, bisphenol AD, bisphenol S, tetramethylbisphenol A, tetramethylbisphenol F, tetramethylbisphenol AD, tetramethylbisphenol S, and tetrafluorobisphenol A being glycidylated, biphenyl epoxy resins, epoxy resins with dihydric phenols such as dihydroxynaphthalene and 9,9-bis(4-hydroxyphenyl)fluorene being glycidylated, epoxy resins with trisphenols such as 1,1,1-tris(4-hydroxyphenyl)methane being glycidylated, epoxy resins with tetrakisphenols such as 1,1,2,2-tetrakis(4-hydroxyphenyl)ethane being glycidylated, and novolac epoxy resins with novolacs such as phenol novolac, cresol novolac, bisphenol A novolac, and brominated bisphenol A novolac being glycidylated.

Among the examples of the epoxy resin, the polyfunctional epoxy resin is a particularly preferred example.

The polyfunctional epoxy resin needs only to be an epoxy resin having three or more epoxy groups in one molecule, and is preferably an epoxy resin having four or more epoxy groups in one molecule.

A molecular weight of the polyfunctional epoxy resin is preferably 600 or less, more preferably 100 or more or 590 or less, and even more preferably 200 or more or 580 or less. In addition, from the viewpoint of achieving lower moisture absorption and higher crosslinking, the resin preferably does not include an amine-based or amide-based structure containing a nitrogen atom.

An epoxy equivalent of the polyfunctional epoxy resin is more preferably 75 g/equivalent or more from the viewpoint of retaining the heat resistance of the resin sheet of the present invention. On the other hand, from the viewpoint of solubility in a solvent, the epoxy equivalent is preferably 200 g/equivalent or less, more preferably 180 g/equivalent or less, even more preferably 160 g/equivalent or less, and still even more preferably 150 g/equivalent or less.

In addition, it is preferable to contain a high molecular weight epoxy compound (also referred to as "epoxy polymer") having a mass average molecular weight of more than 5000.

When the present thermosetting resin composition contains the epoxy polymer, a stronger crosslinked structure can be formed. On the other hand, a curing reaction rate of the present thermosetting resin composition can be reduced, the stability can be improved, and, for example, the shelf life can be enhanced. Further, even when the content proportion of the present filler, for example, the boron nitride aggregate particles is increased, the handleability (brittleness) can be maintained well.

Examples of the epoxy polymer can include phenoxy resins having at least one backbone selected from the group consisting of a bisphenol A backbone, a bisphenol F backbone, a bisphenol A/F mixed backbone, a naphthalene backbone, a fluorene backbone, a biphenyl backbone, an anthracene backbone, a pyrene backbone, a xanthene backbone, an adamantane backbone, and a dicyclopentadiene backbone.

A mass average molecular weight (Mw) of the epoxy polymer is preferably more than 5000, more preferably 10000 or more, even more preferably 15000 or more, still even more preferably 20000 or more, and yet still even more preferably 25000 or more. The upper limit is, for example, 100000 or less. When the mass average molecular weight is within these ranges, the handleability of the resin sheet of the present invention tends to be improved. In addition, film-forming properties of the present thermosetting resin composition are improved. The improvement provides an effect of binding the fillers to each other, and thus voids are less likely to be generated.

The epoxy polymer preferably has an epoxy equivalent of 5000 g/equivalent or more, more preferably 7000 g/equivalent or more, and even more preferably 8000 g/equivalent or more, from the viewpoint of ensuring flexibility of the present thermosetting resin composition. On the other hand, from the viewpoint of solubility in a solvent, the epoxy equivalent is preferably 25000 g/equivalent or less, and more preferably 20000 g/equivalent or less.

The mass average molecular weight is a value in terms of polystyrene as measured by gel permeation chromatography.

The epoxy equivalent is defined as "mass of an epoxy resin containing 1 equivalent of epoxy group", and can be measured according to JIS K7236.

### Orientation of Present Filler in Resin Sheet of Present Invention

In a known heat dissipation sheet formed of a resin sheet containing a filler, it has been said that the peak area intensity ratio obtained by X-ray diffraction measurement using a focusing method (hereinafter, also simply referred to as "focusing method") is correlated with the thermal conductivity of the resin sheet. However, it has been confirmed that there is a difference in thermal conductivity even when the Po value described later obtained by the focusing method is the same, and it has been found that the correlation between the orientation of the filler and the thermal conductivity cannot be sufficiently explained only by the peak area intensity ratio measured by the focusing method. The present inventors have found that the thermal conductivity of a resin sheet can be increased by combining a peak area intensity ratio obtained by measurement using the focusing method and a peak area intensity ratio obtained by measurement using an In-Plane X-ray diffraction method (hereinafter, also simply referred to as "In-Plane method") and defining the combination. The present inventors have conceived the present invention based on such a finding. That is, as described above, the focusing method can measure the orientation of the filler in the entire sheet, whereas the in-plane method can measure the orientation of the filler in the vicinity of the sheet surface. Thus, it has been found that, by combining measurement results from both of the methods and defining the combination, the orientation of the filler based on the X-ray diffraction measurement results and the thermal conductivity of the resin sheet can be associated with each other, and the thermal conductivity of the resin sheet can be increased.

### Ratio (Pi/Po)

In the resin sheet of the present invention, from the viewpoint of increasing the thermal conductivity, a ratio (Pi/Po) of a peak area intensity ratio Pi ((002)/(100)) to a peak area intensity ratio Po ((002)/(100)) is preferably 0.13 or more and 0.41 or less, the peak area intensity ratio Pi ((002)/(100)) being a peak area intensity ratio between a (002) plane of the present filler and a (100) plane of the present filler in the resin sheet, the peak area intensity ratio Pi being obtained by measuring the resin sheet by the in-plane method, the peak area intensity ratio Po ((002)/(100)) being a peak area intensity ratio between the (002) plane of the present filler and the (100) plane of the present filler in the resin sheet, and the peak area intensity ratio Po being obtained by measuring the resin sheet by the focusing method.

As described above, the peak area intensity ratio Pi ((002)/(100)) of the present filler in the resin sheet obtained by measurement by the in-plane method is an index indicating the orientation of the present filler in the vicinity of the sheet surface, particularly a degree of orientation of the present filler in the sheet thickness direction. On the other hand, the peak area intensity ratio Po ((002)/(100)) of the present filler in the resin sheet obtained by measurement by the focusing method is an index indicating the orientation of the present filler in the entire sheet, particularly a degree of orientation of the present filler in the lateral direction of the sheet, that is, the sheet surface direction. It is considered that the ratio (Pi/Po) indicates a tendency of an orientation state in the vicinity of the sheet surface in an orientation state of the present filler in the entire sheet, particularly a degree of orientation of the present filler in the sheet thickness direction. Therefore, when the ratio (Pi/Po) is 0.13 or more and 0.41 or less, the ratio (Pi/Po) is a relatively high value. Thus, when viewed from the entire sheet, particularly in the vicinity of the surface, the primary particles of the present filler are in a state of being more oriented in the sheet thickness direction, and heat is easily diffused in the vicinity of a heat source. Further, a thermal conduction path is easily molded from the surface to the inside of the film thickness, and the thermal conductivity of the entire resin sheet is improved. In addition, since the ratio (Pi/Po) is not too high, contact between a heat dissipation surface and the present filler and/or contact between the present fillers do not become point contact(s), and thermal contact resistance does not increase.

From such a viewpoint, the ratio (Pi/Po) is preferably 0.13 or more, more preferably 0.15 or more, even more preferably 0.18 or more, still even more preferably 0.20 or more, and yet still even more preferably 0.22 or more. On the other hand, an upper limit value of the ratio (Pi/Po) is preferably 0.41 or less, and more preferably 0.40 or less.

In the present invention, the "orientation of the filler" means the orientation of primary particles when the filler is an aggregate formed of primary particles.

Examples of conditions under which the ratio (Pi/Po) can be adjusted can include adjusting pressing conditions (pressure, temperature, time, number of times), adjusting the type and the content of each component in the resin sheet of the present invention and the type and the content of the present filler, and adjusting aging conditions of the resin sheet of the present invention. However, the conditions are not limited thereto.

At present, a method of adjusting the ratio (Pi/Po) within the above range by molding the present thermosetting resin composition containing the present filler and the thermosetting resin into a coating film form or a sheet form, subjecting the composition to low-temperature aging, then applying pressure to the composition while considering the pressing conditions so that the pressing temperature does not become too high, the pressing pressure does not become too high, and the pressing time does not become too long, and further applying pressure to the composition while thermally curing the composition is considered to be preferable. In order to adjust the ratio (Pi/Po) within the above range, the applying pressure may be performed several times. However, the method is not limited to this method.

### Pi ((002)/(100)) and Po ((002)/(100))

In the resin sheet of the present invention, a peak area intensity ratio Pi ((002)/(100)) between a (002) plane of the present filler and a (100) plane of the present filler in the resin sheet, the peak area intensity ratio Pi being obtained by measuring the resin sheet using the in-plane method, is preferably 1.5 or more and 10.0 or less, and a peak area intensity ratio Po ((002)/(100)) between the (002) plane of the present filler and the (100) plane of the present filler in the resin sheet, the peak area intensity ratio Po being obtained by measuring the resin sheet using the focusing method, is preferably 9.0 or more and 13.0 or less.

By defining the numerical ranges of both the peak area intensity ratio Pi ((002)/(100)) obtained by measurement using the in-plane method and the peak area intensity ratio Po ((002)/(100)) obtained by measurement using the focusing method, as seen above, the tendency of the orientation state in the vicinity of the sheet surface in the orientation state of the present filler in the entire sheet, particularly the degree of orientation of the present filler in the sheet thickness direction, can be specified, and the thermal conductivity of the resin sheet of the present invention can be increased.

### Pi ((002)/(100))

The peak area intensity ratio Pi ((002)/(100)) of the present filler in the resin sheet obtained by measurement using the in-plane method is an index indicating the orientation of the present filler in the vicinity of the sheet surface (at a depth of about 1 to 50 µm from the surface), particularly the degree of orientation of the present filler in the sheet thickness direction. Thus, the peak area intensity ratio Pi ((002)/(100)) is preferably 1.5 or more, since such a numerical range indicates that the degree of orientation in the sheet thickness direction of the primary particles of the present filler in the vicinity of the sheet surface is relatively high. On the other hand, the peak area intensity ratio Pi ((002)/(100)) is preferably 10.0 or less, because it is possible to prevent the primary particles of the present filler from being excessively oriented in the sheet thickness direction, and the present fillers with the primary particles laid horizontally, in other words, oriented in the sheet surface direction, are present in an appropriate amount to an extent that the fillers can be in surface contact with each other, and thus, a thermal conduction path is easily formed and the thermal conductivity is improved.

From such a viewpoint, the peak area intensity ratio Pi ((002)/(100)) is preferably 1.5 or more, more preferably 1.7 or more, even more preferably 2.0 or more, still even more preferably 2.5 or more, and yet still even more preferably 3.0 or more. On the other hand, the peak area intensity ratio Pi ((002)/(100)) is preferably 10.0 or less, more preferably 8.0 or less, even more preferably 7.0 or less, and still even more preferably 6.0 or less.

### Po ((002)/(100))

On the other hand, the peak area intensity ratio Po ((002)/(100)) of the present filler in the resin sheet obtained by measurement using the focusing method is preferably 9.0 or more, because such a numerical range indicates that, in the entire sheet, the degree of orientation of the primary particles of the present filler in the sheet surface direction is relatively high, and it is possible to prevent the primary particles of the present filler from being excessively oriented in the thickness direction, and the present fillers with the primary particles laid horizontally, in other words, oriented in the sheet surface direction, are present in an appropriate amount to an extent that the fillers can be in surface contact with each other, and thus, a thermal conduction path is easily formed and the thermal conductivity is improved.

On the other hand, the peak area intensity ratio Po ((002)/(100)) is preferably 13 or less, because the degree to which the primary particles of the present filler are oriented in the sheet surface direction is not excessively high in the entire sheet, and thus the primary particles of the present filler are moderately oriented in the sheet thickness direction, and the thermal conductivity is improved.

From such a viewpoint, the peak area intensity ratio Po ((002)/(100)) is preferably 9.0 or more, more preferably 9.5 or more, even more preferably 10.0 or more, and still even more preferably 10.5 or more. On the other hand, the peak area intensity ratio Po ((002)/(100)) is preferably 13.0 or less, more preferably 12.8 or less, even more preferably 12.6 or less, and still even more preferably 12.4 or less.

Examples of conditions under which the peak area intensity ratios Pi and Po can be adjusted within the above ranges can include adjusting pressing conditions (pressure, temperature, time, number of times), adjusting the type and content of each component in the resin sheet of the present invention and the type and the content of the present filler, and adjusting aging conditions of the resin sheet of the present invention. However, the conditions are not limited thereto.

At present, a method of adjusting the ratio (Pi/Po) within the above range by molding the present thermosetting resin composition containing the present filler and the thermosetting resin into a coating film form or a sheet form, subjecting the composition to low-temperature aging, then applying pressure to the composition while considering the pressing conditions so that the pressing temperature does not become too high, the pressing pressure does not become too high, and the pressing time does not become too long, and further applying pressure to the composition while thermally curing the composition is considered to be preferable. In order to adjust the ratio (Pi/Po) within the above range, the applying pressure may be performed several times. However, the method is not limited to this method.

### Ratio (Pi/Po) and Pi ((002)/(100))

In the resin sheet of the present invention, it is more preferable that the ratio (Pi/Po) is within the above range and the peak area intensity ratio Pi ((002)/(100)) is within the above range.

As described above, the peak area intensity ratio Pi ((002)/(100)) is the index indicating the degree of orientation in the sheet thickness direction of the primary particles of the present filler in the vicinity of the sheet surface, and the ratio (Pi/Po) is the index indicating the degree of orientation in the sheet thickness direction of the primary particles of the present filler in the entire sheet, in particular, the present filler in the vicinity of the sheet surface in the present filler in the entire sheet.

Thus, both the ratio (Pi/Po) and the peak area intensity ratio Pi ((002)/(100)) of the resin sheet of the present invention are preferably within the above ranges, because the primary particles of the present filler in the vicinity of the sheet surface and the primary particles of the present filler in the entire sheet film thickness are also moderately oriented in the sheet thickness direction, and the thermal conductivity of the resin sheet of the present invention can be further increased.

### Ratio (Pi/Po) and Po ((002)/(100))

Further, in the resin sheet of the present invention, it is more preferable that the ratio (Pi/Po) is within the above range and the peak area intensity ratio Po ((002)/(100)) is within the above range.

As described above, preferably, the peak area intensity ratio Po ((002)/(100)) is 9.0 or more, particularly 9.5 or more, because such a numerical range indicates that, in the entire sheet, the degree of orientation of the primary particles of the present filler in the sheet surface direction is relatively high, and it is possible to prevent the primary particles of the present filler from being excessively oriented in the thickness direction, and the present fillers with the primary particles laid horizontally, in other words, oriented in the sheet surface direction, are present in an appropriate amount to an extent that the fillers can be in surface contact with each other, and thus, a thermal conduction path is easily formed and the thermal conductivity is improved.

On the other hand, preferably, the peak area intensity ratio Po ((002)/(100)) is 13.0 or less, particularly 12.8 or less, because the degree to which the primary particles of the present filler are oriented in the sheet surface direction is not excessively high in the entire sheet, and thus, the primary particles of the present filler are moderately oriented in the sheet thickness direction and the thermal conductivity is improved.

Thus, when both the ratio (Pi/Po) and the peak area intensity ratio Po ((002)/(100)) of the resin sheet of the present invention are within the above ranges, the thermal conductivity of the resin sheet of the present invention can be more increased than that when the ratio (Pi/Po) is within the above range.

### Ratio (Pi/Po), Pi ((002)/(100)), and Po ((002)/(100))

Further, from the viewpoint of further increasing the thermal conductivity, it is more preferable that the ratio (Pi/Po) is within the above range, the peak area intensity ratio Pi ((002)/(100)) is within the above range, and the peak area intensity ratio Po ((002)/(100)) is within the above range, in the resin sheet of the present invention.

### Thickness

A thickness of the resin sheet of the present invention is not particularly limited.

When the resin sheet of the present invention is used in, for example, a power semiconductor device, an industrial device, a vehicle, or power generation energy, the thickness of the resin sheet of the present invention is preferably 80 µm or more, more preferably 100 µm or more, even more preferably 110 µm or more, and still even more preferably 120 µm or more. On the other hand, an upper limit value of the thickness is preferably 300 µm or less, more preferably 250 µm or less, even more preferably 220 µm or less, still even more preferably 200 µm or less, and yet still even more preferably 180 µm or less.

By setting the thickness of the resin sheet of the present invention to 80 µm or more, not only high heat dissipation properties, but also sufficient withstand voltage characteristics can be ensured. On the other hand, when the thickness is 300 µm or less, for example, a power semiconductor device using the resin sheet of the present invention can be reduced in size or thickness, and an effect of reducing thermal resistance in the sheet thickness direction by reduction in thickness can be obtained as compared with an insulating thermally conductive layer made of a ceramic material.

### Physical Properties of Resin Sheet of Present Invention

The resin sheet of the present invention can have the following physical properties.

### Thermal Conductivity

A thermal conductivity of the resin sheet of the present invention in the sheet thickness direction at 25°C is preferably 10 W/m·K or more, more preferably 13 W/m·K or more, and particularly preferably 16 W/m·K or more.

When the thermal conductivity of the resin sheet of the present invention in the sheet thickness direction is equal to or higher than the above lower limit value, the resin sheet can be suitably used even in, for example, a power semiconductor device operated at a high temperature.

The thermal conductivity of the resin sheet of the present invention in the thickness direction can be measured by the following method.

For example, the thermal conductivity can be determined from a slope of a graph obtained by plotting the thermal resistance value against the thickness, using a thermal resistance measurement apparatus.

### Method for Manufacturing Resin Sheet of Present Invention

The resin sheet of the present invention can be manufactured, for example, by molding the present thermosetting resin composition containing the present filler and the thermosetting resin into a coating film form or a sheet form, preferably followed by low-temperature aging, pressure application, and thermal curing.

### Present Thermosetting Resin Composition

The present thermosetting resin composition contains the present filler, the thermosetting resin, and the like, and is preferably made into a coating liquid by further adding an organic solvent.

As used herein, the "thermosetting resin composition" means a composition containing a resin having a property of being cured by heat. That is, the composition needs only to be a curable composition with remaining heat-curability, and may be a composition that has been already cured in a state where heat-curability is remained (also referred to as "temporarily cured"), or may be a composition in a state of being uncured (referred to as "uncured") at all.

Among these, the present thermosetting resin composition preferably contains an epoxy resin as the thermosetting resin, and the present filler preferably contains boron nitride aggregate particles from the viewpoint of water resistance and low relative permittivity.

The present thermosetting resin composition may be a composition further containing, in addition to the thermosetting resin and the filler (the present filler and the additional filler), an additional polymer, a curing agent, a curing catalyst, an organic solvent, and an additional component as necessary. Known ones can be used as these polymers, curing agents, curing catalysts, organic solvents and the additional components. Examples thereof can include compositions described in WO 2021/085593, and WO 2023/189030, for example.

In the present thermosetting resin composition, a content of the thermosetting resin is preferably 5 mass% or more and 99 mass% or less based on 100 mass% of a solid content with all the fillers (the present filler and additional filler) being excluded from a total solid content of the present thermosetting resin composition.

The content of the thermosetting resin is preferably 5 mass% or more, because moldability is enhanced, and on the other hand, the content is preferably 99 mass% or less, because a content of the additional component can be ensured and the thermal conductivity can be increased.

From such a viewpoint, the content of the thermosetting resin is preferably 5 mass% or more, more preferably 10 mass% or more, even more preferably 20 mass% or more, still even more preferably 30 mass% or more, yet still even more preferably 40 mass% or more, and yet still even more preferably 50 mass% or more, while the thermosetting resin is contained in a proportion of preferably 99 mass% or less, and more preferably 98 mass% or less, based on 100 mass% of the solid content with all the fillers being excluded from the total solid content of the present thermosetting resin composition.

The "total solid content" in the present thermosetting resin composition is all components excluding the solvent, that is, all the fillers (the present filler and additional filler) and the resin components.

In this case, the "resin components" are the thermosetting resin and an additional organic component and the "additional organic component" includes a curing agent, a curing catalyst, a dispersant, and a viscosity modifier, for example.

In the present thermosetting resin composition, a content of all the fillers (the present filler and the additional filler) is preferably 40 mass% or more and 95 mass% or less based on 100 mass% of the total solid content of the present thermosetting resin composition.

When the content of all the fillers is 40 mass% or more, the thermal conductivity can be increased, and on the other hand, when the content is 95 mass% or less, the adhesion and the insulation can be enhanced.

From such a viewpoint, the content of the all the fillers is preferably 40 mass% or more, more preferably 50 mass% or more, and even more preferably 60 mass% or more, based on 100 mass% of the total solid content of the present thermosetting resin composition. On the other hand, the content is preferably 95 mass% or less, more preferably 90 mass% or less, and still more preferably 85 mass% or less.

When the present thermosetting resin composition contains an epoxy resin as the thermosetting resin and contains boron nitride aggregate particles as the present filler, a content proportion of the boron nitride aggregate particles is preferably 40 mass% or more and 95 mass% or less, more preferably 45 mass% or more or 90 mass% or less, and even more preferably 50 mass% or more or 85 mass% or less, based on 100 mass% of the total solid content of the present thermosetting resin composition.

The content of the epoxy resin is preferably 20 mass% or more and 100 mass% or less, more preferably 40 mass% or more or 95 mass% or less, and even more preferably 50 mass% or more or 90 mass% or less, based on 100 mass% of a total amount of the "resin components".

The "epoxy resin" as used herein includes an epoxy compound, a polyfunctional epoxy resin, and an epoxy polymer.

### Mixing

In preparing the present thermosetting resin composition, it is preferable to uniformly mix the components by stirring or kneading and thus, form a slurry. For the mixing, a general kneading apparatus such as a mixer, a kneader, and a single-screw or twin-screw kneader can be used, and at the time of the mixing, heating may be performed as necessary. When heat is generated by the stirring or the kneading, cooling may be performed.

When an organic solvent is added to the present thermosetting resin composition to prepare the resultant in a slurry state having fluidity, mixing and stirring is performed preferably using, for example, a general kneading apparatus such as a paint shaker, a bead mill, a planetary centrifugal mixer, a stirring type disperser, a planetary stirring mixer, a rotary homogenizer, three rolls, a kneader, or a single-screw or twin-screw kneader, for the purpose of improving uniformity of the coating liquid and defoaming, for example.

As the organic solvent, a solvent that dissolves a resin, among known solvents, can be appropriately used. Examples of the organic solvent can include methyl ethyl ketone, acetone, cyclohexanone, toluene, xylene, monochlorobenzene, dichlorobenzene, trichlorobenzene, phenol, and hexafluoroisopropanol. One of these may be used alone, or two or more thereof may be used in combination.

The organic solvent is used in an amount of usually from 0 to 10000 parts by mass based on 100 parts by mass of the total solid content.

### Formation into Sheet Form or Coating Film Form

The present thermosetting resin composition prepared into a slurry is applied to a surface of a substrate and a sheet-shaped coating film is formed, for example.

In this case, as an application method, a dipping method, a spin coating method, a spray coating method, a blade method, or any other method can be adopted. In the application of the present thermosetting resin composition, a uniform coating film having a predetermined thickness can be formed on a substrate by using an application apparatus such as a spin coater, a slit coater, a die coater, a blade coater, a comma coater, screen printing, a doctor blade, an applicator, or spray coating. In particular, a blade coater capable of adjusting a gap is preferable.

The resin sheet of the present invention can also be used as a self-supporting film, and can be formed on a known substrate such as a metallic foil or plate (copper, aluminum, silver, gold), a resin film of, for example, polyethylene terephthalate and polyethylene naphthalate, or glass.

Depending on the form of use, the resin sheet of the present invention may be separated from the substrate, or a laminate structure such as the structure of a substrate/the resin sheet of the present invention/the substrate may be used.

In this case, a copper foil having a thickness described below is generally used as the substrate, but the substrate is not limited to the copper substrate. The surface of the substrate may have irregularities or may be subjected to surface treatment.

### Low-Temperature Aging

The present thermosetting resin composition is preferably subjected to low-temperature aging, which includes placing the present thermosetting resin composition in a temperature environment of 0°C or lower. For example, the present thermosetting resin composition molded as described above and having a sheet shape is preferably subjected to low-temperature aging, including placing the present thermosetting resin composition in a temperature environment of 0°C or lower.

By subjecting the present thermosetting resin composition having a sheet shape to such low-temperature aging, moisture inside the sheet can be frozen and dispersed as minute ice. By forming small chambers of moisture confined in minute spaces even after returning to room temperature, the occurrence of cracking when the sheet is bent can be suppressed by moisture retention while preventing deterioration of the insulation without generating large voids. In addition, fine voids are highly dispersed in the sheet, the fluidity of the resin components in applying pressure is increased, and rearrangement of the present filler, for example, the boron nitride aggregate particles is likely to occur, and the contact between the present fillers increases, and thus the thermal conductivity can be increased. In addition, from the effect of stress relaxation, cracking and deformation are less likely to occur in the resin sheet of the present invention.

The low-temperature aging may be performed at any timing, but from the viewpoint of the effect of rearranging and orienting the filler, it is preferable to perform the low-temperature aging after molding the present thermosetting resin composition into a coating film form or a sheet form and before applying pressure to the present thermosetting resin composition.

A temperature (environmental temperature) in the low-temperature aging is preferably lower because the higher the cooling rate, the smaller the ice. From such a viewpoint, the environmental temperature is preferably 0°C or lower, more preferably -5°C or lower, even more preferably -10°C or lower, and still even more preferably -15°C or lower. On the other hand, if the temperature is too low, the temperature becomes not higher than a glass transition temperature (Tg) of the thermosetting resin in an uncured state and the resin is liable to crack. Thus, the temperature is preferably -50°C or higher. When an epoxy resin is contained, the temperature is more preferably -30°C or higher, and even more preferably -25°C or higher.

A time for the low-temperature aging is not particularly limited as long as the present thermosetting resin composition is frozen. The present thermosetting resin composition may be quickly frozen and held for 10 minutes or more, preferably 30 minutes or more, more preferably 1 hour or more, even more preferably 2 hours or more, still even more preferably 4 hours or more, yet still even more preferably 8 hours or more, yet still even more preferably 16 hours or more, and yet still even more preferably 24 hours or more. On the other hand, since the reaction of the epoxy resin gradually proceeds even at a low temperature, from the viewpoint of avoiding leaving the epoxy resin to stand for a long period of time, the time is preferably 365 days or less, more preferably 180 days or less, even more preferably 90 days or less, still even more preferably 30 days or less, and yet still even more preferably 7 days or less.

It is not necessary to apply pressure during the low-temperature aging, but a minute pressure of 0.1 kPa or less may be applied.

The low-temperature aging may be performed after the subsequent pressure application.

### Pressure application

Next, after drying as necessary, it is preferable to apply pressure in a temperature range that the epoxy resin is not cured.

Examples of a pressure application method can include calender pressing, flat plate pressing, compression molding, and isostatic pressing. However, the method is not limited to these methods.

The pressure application is preferably performed by calender pressing under conditions of, for example, a linear pressure of 20 to 200 kgf/cm applied to the sheet and a roller temperature of 0 to 50°C.

Specifically, the linear pressure applied to the sheet in the calender pressing is preferably from 20 to 200 kgf/cm, more preferably 25 kgf/cm or more or 150 kgf/cm or less, and even more preferably 30 kgf/cm or more or 125 kgf/cm or less.

The roller temperature is preferably from 0 to 50°C, more preferably 5°C or higher or 45°C or lower, and even more preferably 10°C or higher or 40°C or lower. The roller temperature can be regarded as the same temperature as a product temperature of the present thermosetting resin composition.

A normal calender roll machine having 1 or more sets of rollers or 2 or more rollers, the sheet being passed through the set(s) of rolls or the rolls, can be used. Note that the "1 (2)" means that the number of sets of rollers is 1 and the number of rollers is 2. The pressure application time is 10 seconds or less in view of the characteristics of the calender pressing.

The pressure application is preferably performed by flat plate pressing under conditions of, for example, a pressure of 10 to 2000 kgf/cm² applied to the sheet, a metallic flat plate temperature of 0 to 100°C, and a pressure application time of 1 to 1500 seconds, for example.

Specifically, in the case of the flat plate pressing, the pressure applied to the sheet (also referred to as "pressing load") is preferably from 10 to 2000 kgf/cm², more preferably 50 kgf/cm² or more or 1000 kgf/cm² or less, and even more preferably 75 kgf/cm² or more or 500 kgf/cm² or less.

The metallic flat plate temperature (also referred to as "pressing temperature") is preferably from 0 to 100°C, more preferably 5°C or higher or 80°C or lower, and even more preferably 15°C or higher or 50°C or lower. The metallic flat plate temperature can be regarded as the same temperature as the product temperature of the present thermosetting resin composition.

The pressure application time (also referred to as "press pressure application time") is preferably from 1 to 1500 seconds, more preferably 2 seconds or more or 1000 seconds or less, and even more preferably 3 seconds or more or 500 seconds or less.

### Curing

After the pressure application, the sheet can be cured (thermally cured) by heating while applying pressure to the sheet as necessary (this pressure application is also referred to as "curing pressing").

The thermal curing is preferably performed by heating to 80 to 300°C and pressure application at a pressure of 50 to 2000 kgf/cm² for 0.5 to 240 minutes, for example.

Specifically, an upper plate portion and a lower plate portion of a pressing machine are heated in advance, and the sheet is set in the pressing machine and pressure is applied by the upper plate portion and lower plate portion, and thus, the pressure application and the heating can be performed simultaneously.

At this time, the heating temperature of the plate portions is preferably from 80 to 300°C, more preferably 100°C or higher, and even more preferably 120°C or higher. On the other hand, especially, the heating temperature is preferably 280°C or lower, more preferably 250°C or lower, and even more preferably 220°C or lower.

The heating time is preferably from 0.5 to 240 minutes, more preferably 1 minute or more or 180 minutes or less, even more preferably 5 minutes or more or 120 minutes or less, and still even more preferably 10 minutes or more or 60 minutes or less.

The pressure applied during the curing is preferably from 50 to 2000 kgf/cm², more preferably 60 kgf/cm² or more or 1500 kgf/cm² or less, even more preferably 70 kgf/cm² or more or 1000 kgf/cm² or less, still even more preferably 80 kgf/cm² or more or 500 kgf/cm² or less, and still even more preferably 90 kgf/cm² or more or 200 kgf/cm² or less.

### Use of Resin Sheet of Present Invention

The resin sheet of the present invention can be used as a constituent material of a heat dissipation laminate (referred to as "the present heat dissipation laminate"), a heat dissipating circuit board (referred to as "the present heat dissipating circuit board"), a semiconductor device (referred to as "the present semiconductor device"), and a power semiconductor device (referred to as "the present power semiconductor device"), for example,. That is, the resin sheet of the present invention is preferably used as a heat dissipation member of a power semiconductor device. However, the use of the resin sheet of the present invention is not limited to such use.

### Heat dissipation laminate

An example of the present heat dissipation laminate can be a laminate in which a metallic layer for heat dissipation containing a heat dissipating material is laminated on one surface of the resin sheet of the present invention.

The heat dissipating material is not particularly limited as long as it is made of a material having good thermal conductivity. Especially, in order to increase the thermal conductivity in the laminated configuration, it is preferable to use a metallic material for heat dissipation, and it is more preferable to use a flat plate-shaped metallic material. Further, a cooler having a rod-shaped or plate-shaped fin attached to a lower portion of a flat plate-shaped metal may be used.

A material for the metallic material is not particularly limited. Especially, a copper plate, an aluminum plate, an aluminum alloy plate, and the like are preferable from the viewpoint of good thermal conductivity and relatively low cost.

For the lamination and integration of the resin sheet of the present invention and the metallic layer for heat dissipation, press molding, which is a batch process, can be preferably used. Press equipment and pressing conditions in this case are the same as the ranges of the press molding conditions for yielding the resin sheet of the present invention as described above.

### Heat Dissipating Circuit Board

An example of the present heat dissipating circuit board can be a circuit board having a configuration in which the metallic layer for heat dissipation is laminated on one surface of the resin sheet of the present invention, and a circuit board is formed on the other surface of the resin sheet of the present invention by, for example, etching. Specifically, the circuit board is more preferably an integrated product of "the metallic layer for heat dissipation/the resin sheet of the present invention/a conductive circuit". Examples of the state before circuit etching can include a structure having an integrated configuration of "the metallic layer for heat dissipation/the resin sheet of the present invention/a metallic layer for forming a conductive circuit", the metallic layer for forming a conductive circuit having a flat plate shape, and being formed on the entire surface on one side of the resin sheet of the present invention or on a part of the surface on one side of the resin sheet of the present invention.

A material for the metallic layer for forming a conductive circuit is not particularly limited. In particular, it is generally preferable to employ a thin copper plate having a thickness of 0.05 mm or more and 1.2 mm or less from the viewpoint of electrical conductivity, good etchability, and cost, for example.

### Semiconductor Device

An example of the present semiconductor device can be a semiconductor device having a configuration in which a silicon wafer or a rewiring layer with a pre-singulated semiconductor chip being mounted is formed on the present heat dissipating circuit board.

### Power Semiconductor Device

The present power semiconductor device may be any power semiconductor device as long as it is a product in which a circuit including a combination of a plurality of power semiconductors is integrated in a one-package module, and is provided with the resin sheet of the present invention.

An example of the present power semiconductor device can be a power semiconductor device with a power semiconductor mounted on the present heat dissipating circuit board.

In the present power semiconductor device, a known member can be appropriately adopted as a member other than the resin sheet of the present invention. Examples of the known member include an aluminum wiring, a sealing material, a package material, a heat sink, a thermal paste, and solder.

### Explanation of Terminology and Phrases

In the present invention, the term "film" also includes the term "sheet", and the term "sheet" also includes the term "film".

In the present invention, when the phrase "from α to β" (α and β are any numbers) is described, unless otherwise specified, the phrase includes the meaning of "α or more and β or less" and the meaning of "preferably more than α" or "preferably less than β".

In addition, when the phrase "α or more" or "α ≤" (α is any number) is described, the phrase includes the meaning of "preferably more than α" unless otherwise specified, and when the phrase "β or less" or "≤ β" (β is any number) is described, the phrase includes the meaning of "preferably less than β" unless otherwise specified.

### Examples

Hereinafter, examples of the present invention will be described in detail. However, the present invention is not limited to Examples described below.

### <Raw Material>

- Epoxy resin 1: high molecular weight epoxy resin (mass average molecular weight in terms of polystyrene: 30000, epoxy equivalent: 9000 g/equivalent, density: about 1.2 g/cm³)
- Epoxy resin 2: polyfunctional epoxy resin having a structure having four or more glycidyl groups in one molecule (molecular weight: 500 or less, density: about 1.2 g/cm³)
- Epoxy resin 3: biphenyl solid epoxy resin (molecular weight: about 400, density: about 1.2 g/cm³)
- Boron nitride aggregate particles: spherical boron nitride aggregate particles having a card-house structure, the spherical boron nitride aggregate particles being aggregate particles formed by aggregation of plate-shaped primary particles (average particle size (D50): 45 µm, maximum particle size (Dmax): 90 µm, modulus of elasticity: 65 MPa, crushing strength: 6 MPa)

The maximum particle size (Dmax) and the average particle size (D50) of the boron nitride aggregate particles are a maximum particle size Dmax and a volume-based cumulative 50% particle size (average particle size D50) determined by dispersing the boron nitride aggregate particles in a pure water medium containing a naphthalene sulfonate-formalin condensate as a dispersion stabilizer, measuring a volume-based particle size distribution with a laser diffraction/scattering particle size distribution analyzer LA-300 (available from HORIBA, Ltd.), and identifying the maximum particle size Dmax and the volume-based cumulative 50% particle size from the obtained particle size distribution.

The modulus of elasticity and the crushing strength of the boron nitride aggregate particles were measured by the following methods.

The crushing strength of the boron nitride aggregate particles was measured using a microcompression tester (available from Shimadzu Corporation, product name "MCT-510"). A very small amount of a sample was spread on a compression plate installed at a lower portion of the microcompression tester, a compression test was performed for each particle, and the crushing strength was determined from a breaking test force when the particle was broken and the particle size of the particle, using a formula described below. The measurement was performed for five particles, and an average value thereof was taken as the crushing strength of the boron nitride aggregate particles. $Cs = 2.48 P / {πd}^{2}$

In the above formula, "Cs" is the crushing strength (MPa), "P" is the breaking test force (N), and "d" is the particle size (mm).

Usually, the crushing strength is calculated using the test force at a breaking point, but when the breaking point is not clear (for example, the sample is deformed but does not cause rapid breakage), the test force when 10% deformation is given is used as a reference strength, and is used as 10% strength for comparison. The 10% strength was calculated from a formula described below. $Cx = 2.48 P / {πd}^{2}$

In the above formula, "Cx" is the 10% strength (MPa), "P" is a test force (N) at 10% displacement of the particle size, and "d" is the particle size (mm).

The modulus of elasticity of the boron nitride aggregate particles was calculated from the following formula using the apparatus used for measuring the crushing strength, based on the test force and the compression displacement at the time of occurrence of breakage. $E = 3 \times \left(1-{ν}^{2}\right) \times P / 4 \times {\left(d/2\right)}^{1 / 2} \times {Y}^{3 / 2}$

In the above formula, "E" is the modulus of elasticity (MPa), "v" is a Poisson's ratio, "P" is the breaking test force (N), "d" is the particle size (mm), and "Y" is the compression displacement (mm). The Poisson's ratio was assumed to be constant (0.13).

### • Aluminum oxide particles: spherical alumina (average particle size (D50): 8.8 µm, thermal conductivity: from 20 to 30 W/m·k)

The average particle size (D50) of the aluminum oxide particles is a volume-based cumulative 50% particle size (average particle size D50) determined by dispersing the aluminum oxide particles in a pure water medium containing a naphthalene sulfonate-formalin condensate as a dispersion stabilizer, measuring a volume-based particle size distribution with a laser diffraction/scattering particle size distribution analyzer LA-300 (available from HORIBA, Ltd.) in a batch mode, and identifying the volume-based cumulative 50% particle size from the obtained particle size distribution.

- Curing agent: phenol resin-based curing agent
- Curing catalyst 1: 2,4-diamino-6-[2'-ethyl-4'-methylimidazolyl-(17')]-ethyl-s-triazine (molecular weight: 247, property: solid, melting point: from 215 to 225°C)
- Curing catalyst 2: 2-phenyl-4,5-dihydroxymethylimidazole (molecular weight: 204, property: solid, melting point: 230°C or higher because of dec. at 230)

### Preparation of Thermosetting Resin Composition

To methyl ethyl ketone and cyclohexanone, 6 parts by mass of the epoxy resin 1, 6 parts by mass of the epoxy resin 2, 11 parts by mass of the epoxy resin 3, 53 parts by mass of the boron nitride aggregate particles, 20 parts by mass of the aluminum oxide particles, 3.5 parts by mass of the curing agent, 0.25 parts by mass of the curing catalyst 1, and 0.25 parts by mass of the curing catalyst 2 was added such that the solid content concentration was 74 mass%, the resultant was mixed using a planetary centrifugal mixer, and thus, a slurry thermosetting resin composition was prepared.

### Example 1

The slurry thermosetting resin composition prepared as described above was applied onto a polyethylene terephthalate (PET) film with an applicator having a gap of 400 µm, dried on a hot plate at 60°C for 60 minutes, and then vacuum-dried at 60°C (heating environment temperature) for 60 minutes, and thus, a sheet having a thickness of 240 µm was produced. The obtained sheet was subjected to low-temperature aging for 72 hours in a freezer in an environment of -20°C without applying any particular load.

A PET film having one surface applied with a release agent was laminated on this sheet such that the applied surface was in contact with the resin, and thus, a laminated sheet formed of the PET film/the thermosetting resin composition/the PET film was formed. This laminated sheet was subjected to calender pressing, the calender pressing including passing the sheet between a pair of metallic rolls at a temperature of 25°C and applying a linear pressure (calender pressure) of 50 kgf/cm once. Next, the laminated sheet was cured by subjecting the laminated sheet to curing pressing using a pressing machine so that a load of 100 kgf/cm2 was applied at 120°C (product temperature) for 40 minutes, and thus, a resin sheet (sample) having a thickness of 150 µm was obtained.

Further, two, three, four or five sheets of the resin sheets (samples) subjected to the calender pressing as described above were laminated and cured under the same conditions as described above, and thus, four types of resin sheets (samples) having different thicknesses were obtained. Thus, together with the resin sheet (sample) formed of one sheet, five types of the cured samples having respective thicknesses corresponding to one sheet to five sheets were obtained.

### Example 2

A resin sheet (sample) was obtained in the same manner as in Example 1, except that the calender pressure was changed from 50 kgf/cm in Example 1 to 100 kgf/cm.

In addition, five types of cured samples having respective thicknesses corresponding to one sheet to five sheets were obtained in the same manner as in Example 1.

### Comparative Example 1

The slurry thermosetting resin composition prepared as described above was applied onto a polyethylene terephthalate (PET) film with an applicator having a gap of 400 µm, dried on a hot plate at 60°C for 60 minutes, and then vacuum-dried at 60°C (heating environment temperature) for 60 minutes, and thus, a sheet having a thickness of 240 µm was produced. The obtained sheet was subjected to low-temperature aging for 72 hours in a freezer in an environment of -20°C without applying any particular load.

A PET film having one surface applied with a release agent was laminated on the sheet such that the applied surface was in contact with the sheet, and thus, a laminated sheet formed of the PET film/the thermosetting resin composition/the PET film was formed. This laminated sheet was set in a pressing machine, subjected to flat plate pressing so that a load of 1500 kgf/cm² (pressing load) was applied for 15 minutes (press pressure application time) at 41.5°C (pressing temperature), and then cured by subjecting the laminated sheet to curing pressing using the pressing machine so that a load of 100 kgf/cm² was applied at 120°C (product temperature) for 40 minutes, and thus, a resin sheet (sample) having a thickness of 150 µm was obtained.

Further, two, three, four or five sheets of the resin sheets (samples) subjected to the flat plate pressing as described above were laminated and cured under the same conditions as described above, and thus, four types of resin sheets (samples) having different thicknesses were obtained. Thus, together with the resin sheet (sample) formed of one sheet, five types of the cured samples having respective thicknesses corresponding to one sheet to five sheets were obtained.

### Example 3

A resin sheet (sample) was obtained in the same manner as in Comparative Example 1, except that the pressing temperature was changed from 41.5°C in Comparative Example 1 to 25°C, the pressing load was changed from 1500 kgf/cm² in Comparative Example 1 to 100 kgf/cm², and the press pressure application time was changed from 15 minutes in Comparative Example 1 to 5 seconds.

In addition, five types of cured samples having respective thicknesses corresponding to one sheet to five sheets were obtained in the same manner as in Comparative Example 1.

### Example 4

A resin sheet (sample) was obtained in the same manner as in Comparative Example 1, except that the pressing load was changed from 1500 kgf/cm² to 100 kgf/cm².

In addition, five types of cured samples having respective thicknesses corresponding to one sheet to five sheets were obtained in the same manner as in Comparative Example 1.

### Comparative Example 2

The slurry thermosetting resin composition prepared as described above was applied onto a polyethylene terephthalate (PET) film with an applicator having a gap of 400 µm, dried on a hot plate at 60°C for 60 minutes, and then vacuum-dried at 60°C (heating environment temperature) for 60 minutes, and thus, a sheet having a thickness of 240 µm was produced. The obtained sheet was subjected to low-temperature aging for 72 hours in a freezer in an environment of -20°C without applying any particular load.

A PET film having one surface applied with a release agent was laminated on this sheet such that the applied surface was in contact with the sheet, and thus, a laminated sheet formed of the PET film/the thermosetting resin composition/the PET film was formed. This laminated sheet was cured by subjecting the laminated sheet to curing pressing using a pressing machine so that a load of 70 kgf/cm² was applied at 170°C (product temperature) for 180 minutes, and thus, a resin sheet (sample) having a thickness of 150 µm was obtained.

Further, two, three, four or five sheets of the resin sheets (samples) subjected to the low-temperature aging as described above were laminated and cured under the same conditions as described above, and thus, four types of resin sheets (samples) having different thicknesses were obtained. Thus, together with the resin sheet (sample) formed of one sheet, five types of the cured samples having respective thicknesses corresponding to one sheet to five sheets were obtained.

### Comparative Example 3

A resin sheet (sample) was obtained in the same manner as in Example 4, except that the low-temperature aging in Example 4 was not performed and aging was performed at 60°C for 72 hours using an air-blowing oven.

In addition, five types of cured samples having respective thicknesses corresponding to one sheet to five sheets were obtained in the same manner as in Comparative Example 1.

### X-Ray Diffraction (XRD)

The resin sheets (samples) obtained in Examples and Comparative Examples were subjected to X-ray diffraction measurement using the in-plane method together with X-ray diffraction measurement using the focusing method.

The X-ray diffraction method using the in-plane method is also simply referred to as an "in-plane method", and the X-ray diffraction method using the focusing method is also simply referred to as a "focusing method".

In both the focusing method and the in-plane method, a sample of 2 cm × 2 cm × 150 µm was placed at a sample position of each diffractometer with a surface perpendicular to the sheet thickness direction facing upward, and the measurement was performed.

The X-ray diffraction measurement using the focusing method was performed using "X' Pert Pro MPD (product name)" available from PANalytical under the following conditions.

- Optical system focusing method
- Radiation source sealed X-ray tube (CuKα)
- Incident-side slit Soller Slit (0.04 rad)
- Divergence Slit (Variable slit)
- Light receiving-side slit Ni-Filter

### Soller Slit (0.04 rad)

- Gonio radius 243 mm
- X-ray output 40 kV 30 mA
- Scanning axis θ/2θ
- Scanning range (2θ) from 10° to 70°
- Measurement mode continuous scanning
- Read width 0.016°
- Measurement time 29.8 sec
- Automatically variable slit 10 mm (irradiation width)
- Lateral divergence mask 10 mm (irradiation width)

The X-ray diffraction measurement using the in-plane method was performed using "SmartLab (product name)" available from Rigaku Corporation under the following conditions.

- Optical system parallel beam method
- Radiation source rotating anode X-ray tube (CuKα)
- Incident-side slit Soller Slit In-Plane PSC 0.5°
- Incident slit 0.100 mm
- Longitudinal limiting slit 10 mm
- Light receiving-side slit light receiving optical unit PSA open
- Soller Slit In-Plane PSA 0.5°
- Light receiving slit 2 20 mm
- X-ray output 45 kV, 200 mA
- Scanning axis 2θχ/Φ (°)
- Incident angle (ω) 0.2°
- Measurement mode step scanning
- Scanning range (2θχ) from 10° to 70°
- Operation step 0.096°
- Scanning speed 2.0°/min
- Goniometer radius 300 mm

In the XRD profiles obtained by the respective measurement methods, areas (I₀₀₂ and I₁₀₀) of the diffraction peak of the (002) plane and the diffraction peak of the (100) plane of the boron nitride aggregate particles were each determined by profile fitting, and the peak area intensity ratio Po ((002)/(100)) and the peak area intensity ratio Pi ((002)/(100)) were calculated.

At this time, in both the XRD profiles of the focusing method and the in-plane method, the diffraction peak of the (002) plane of the boron nitride aggregate particles was the maximum peak in a range that the scanning axis is more than 25.0°and less than 28.0°, and the diffraction peak of the (100) plane was the maximum peak in a range that the scanning axis is more than 40.5°and less than 42.5°. The scanning axis of the focusing method is 2θ, and the scanning axis of the in-plane method is 2θχ.

The profile fitting was performed using XRD analysis software Jade. For each profile, the background was defined by a cubic spline curve, and peak fitting was performed using the Pearson VII function or the pseudo-Voigt function. The peak fitting was performed using the least squares method in the range that 2θ (2θχ) is more than 25.0° and less than 28.0° for the diffraction peak of the (002) plane and in the range that 2θ (2θχ) is more than 40.5° and less than 42.5° for the diffraction peak of the (100) plane.

### Measurement of Thermal Conductivity (λ)

Using the five types of cured samples having different thicknesses produced in Examples and Comparative Examples, measurement was performed under the following conditions (1) to (4), and the thermal conductivities at 25°C in the sheet thickness direction by a steady-state method were measured from slopes represented by the thermal resistance values with respect to the thicknesses of the sheets (in accordance with ASTM D5470).

In the measurement, the probe size was φ 12.8 mm, the constant pressure was 3400 kPa, and the measurement time was 300 sec. In order to increase the adhesion between the cured sample and a probe, "OILL COMPOUND (product name: G-747)" available from Shin-Etsu Chemical Co., Ltd. was used.
(1) Thickness: thickness (µm) when pressed at a pressing pressure of 3400 kPa using "T3Ster-DynTIM" available from Mentor Graphics Corporation.
(2) Measurement area: area (cm²) of a portion that transfers heat when measured using "T3Ster-DynTIM" available from Mentor Graphics Corporation.
(3) Thermal resistance value: thermal resistance value (K/W) when pressed at a pressing pressure of 3400 kPa using "T3Ster-DynTIM" available from Mentor Graphics Corporation.
(4) Thermal conductivity: The thermal resistance values of the five types of cured samples having different thicknesses are measured, and the thermal conductivities (W/m·K) are calculated from the following equation. $Thermal conductivity \left(W/m⋅K\right) = 1 / \left(\left(\begin{matrix}slope \left(thermal resistance value/thickness\right) : \\ K / \left(W⋅μm\right)\end{matrix}\right)\times \left({area : cm}^{2}\right)\right) \times {10}^{- 2}$ Equation.

**[Table 1]**

| | | Unit | Example 1 | Example 2 | Example 3 | Example 4 | Comparative Example 1 | Comparative Example 2 | Comparative Example 3 |
|---|---|---|---|---|---|---|---|---|---|
| | Aging | °C | -20 | -20 | -20 | -20 | -20 | -20 | 60 |
| | | h | 72 | 72 | 72 | 72 | 72 | 72 | 72 |
| | Calender pressing | °C | 25 | 25 | - | - | - | - | - |
| | | kg/cm | 50 | 100 | - | - | - | - | - |
| | Flat plate pressing | °C | - | - | 25 | 41.5 | 41.5 | - | 41.5 |
| Manufacturing method | | kg/cm² | - | - | 100 | 100 | 1500 | - | 100 |
| | | s or min | - | - | 5s | 15 min | 15 min | - | 15 min |
| | Curing pressing | °C | 120 | 120 | 120 | 120 | 120 | 170 | 120 |
| | | kg/cm² | 100 | 100 | 100 | 100 | 100 | 70 | 100 |
| | | min | 40 | 40 | 40 | 40 | 40 | 180 | 40 |
| Resin sheet | Focusing method peak area intensity ratio Po ((002)/(100)) | - | 11.7 | 12.2 | 9.6 | 10.1 | 11.3 | 6.0 | 8.5 |
| | In-plane method peak area intensity ratio Pi ((002)/(100)) | - | 4.7 | 3.2 | 2.2 | 2.0 | 1.4 | 2.9 | 3.6 |
| | Ratio (Pi/Po) | - | 0.40 | 0.26 | 0.23 | 0.20 | 0.12 | 0.48 | 0.42 |
| | Thermal conductivity (λ) | W/m•K | 19.8 | 18.1 | 19.2 | 17.9 | 15.2 | 5.5 | 5.4 |

### Discussion

It was found that all of Examples 1 to 4 exhibited high thermal conductivity and had a ratio (Pi/Po) in a range of 0.13 or more and 0.41 or less. It was also found that all of Examples 1 to 4 had Pi ((002)/(100)) of 1.5 or more and 10.0 or less and Po ((002)/(100)) of 9.0 or more and 13.0 or less.

In contrast, it was found that Comparative Example 1 had a lower Pi ((002)/(100)) and a lower ratio (Pi/Po) and lower thermal conductivity than those of Examples 1 to 4. This is considered to be because the pressure in the flat plate pressing was too high in Comparative Example 1, and thus the primary particles of the filler, particularly, the primary particles of the filler in the vicinity of the surface of the resin sheet were oriented in the sheet surface direction, and thermal conductivity was decreased, as a result.

It was found that Comparative Example 2 had a lower Po ((002)/(100)), a higher ratio (Pi/Po), and lower thermal conductivity than those of Examples 1 to 4. This is considered to be because, in Comparative Example 2, the curing pressing was performed without the calender pressing or the flat plate pressing, and thus, the primary particles of the filler were excessively oriented in the sheet thickness direction on both the surface and the inside of the resin sheet, and thus, the contact between the fillers was not ensured, and thermal conductivity was decreased, as a result.

It was found that Comparative Example 3 had a lower Po ((002)/(100)), a higher ratio (Pi/Po), and lower thermal conductivity than those of Examples 1 to 4. This is considered to be because, in Comparative Example 3, the low-temperature aging was not performed, and thus, rearrangement of the filler was less likely to occur, and primary particles of the filler were excessively oriented in the sheet thickness direction on both the surface and the inside of the resin sheet, and thus, the contact between the fillers was not ensured, and low thermal conductivity was decreased, as a result.

From Examples and Comparative Examples and the results of the tests conducted by the present inventors, it was found that the thermal conductivity can be increased, when the peak area intensity ratio Pi ((002)/(100)) between the (002) plane of the filler and the (100) plane of the filler in the resin sheet, the peak area intensity ratio Pi being obtained by measuring the resin sheet by the In-Plane X-ray diffraction method, is 1.5 or more and 10.0 or less, and the peak area intensity ratio Po ((002)/(100)) between the (002) plane of the filler and the (100) plane of the filler in the resin sheet, the peak area intensity ratio Po being obtained by measuring the resin sheet by the X-ray diffraction method using the focusing method, is 9.0 or more and 13.0 or less.

This can be considered to be due to the following mechanism of action.

The peak area intensity ratio Pi ((002)/(100)) of the present filler in the resin sheet, obtained by measurement by the in-plane method, is considered to be an index indicating the orientation of the present filler in the vicinity of the sheet surface, particularly the degree of orientation of the present filler in the sheet thickness direction.

On the other hand, the peak area intensity ratio Po ((002)/(100)) of the filler in the resin sheet, obtained by measurement by the focusing method, is considered to be an index indicating the orientation of the filler in the entire sheet, particularly the degree of orientation of the filler in the lateral direction of the sheet, that is, the sheet surface direction.

When the primary particles of the filler are oriented in the lateral direction, that is, in the sheet surface direction in the vicinity of the sheet surface, a structure corresponding to a thermal resistance film is formed in a portion in contact with a heating portion, and the thermal contact resistance is significantly increased. Thus, the thermal conductivity of the entire sheet is significantly decreased. On the other hand, it can be considered that when the primary particles of the filler are oriented in the sheet thickness direction in the vicinity of the sheet surface, the thermal conductivity in the vicinity of the sheet surface increases and the thermal contact resistance decreases, and thus, the thermal conductivity of the portion in contact with the heating portion is increased, and the thermal conductivity of the entire sheet is also significantly increased, as a result.

In addition, considering the entire sheet, it can be considered that when the primary particles of the filler are moderately oriented in the sheet surface direction and the primary particles lie horizontally to the extent that the fillers can be in surface contact with each other, in other words, when the filler oriented in the sheet surface direction is present in an appropriate amount, a thermal conduction path is easily formed and the thermal conductivity is improved.

However, it is necessary to pay attention to the fact that, when the primary particles of the filler are excessively oriented in the sheet thickness direction on both the surface and the inside of the resin sheet, the contact between the fillers in the sheet thickness direction is not ensured, and the thermal conductivity is conversely lowered.

In consideration of these points, when the peak area intensity ratio Pi ((002)/(100)) obtained by measurement by the in-plane method is 1.5 or more and 10.0 or less, the peak area intensity ratio Pi ((002)/(100)) is a relatively high value but is not too high. Thus, it can be considered that the primary particles of the filler are oriented in the sheet thickness direction on the sheet surface, but are not excessively oriented. On the other hand, when the peak area intensity ratio Po ((002)/(100)) obtained by measurement by the focusing method is 9.0 or more and 13.0 or less, the peak area intensity ratio Po ((002)/(100)) is a relatively high value but is not too high, and thus, it is indicated that the primary particles of the filler are oriented in the sheet thickness direction even in the entire sheet, but are not excessively oriented, and it can be considered that the thermal conductivity is increased.

In addition, from Examples and Comparative Examples and the results of the tests conducted by the present inventors, it was found that the thermal conductivity can be increased when the ratio (Pi/Po) of the peak area intensity ratio Pi ((002)/(100)) obtained by measuring the resin sheet using the in-plane method to the peak area intensity ratio Po ((002)/(100)) obtained by measuring the resin sheet using the focusing method is 0.13 or more and 0.41 or less.

This can be considered to be due to the following mechanism of action.

The ratio (Pi/Po) is considered to indicate the tendency of the orientation state in the vicinity of the sheet surface in the orientation state of the present filler in the entire sheet, particularly the degree of orientation of the present filler in the sheet thickness direction. Thus, when the ratio (Pi/Po) is within the above range, the ratio (Pi/Po) is a relatively high value. Thus, when viewed from the entire sheet, particularly in the vicinity of the surface, the primary particles of the present filler are in a state of being more oriented in the sheet thickness direction, heat is easily diffused in the vicinity of a heat source, a thermal conduction path is easily molded from the surface to the inside of the film thickness. As a result, it is considered that the thermal conductivity of the entire resin sheet is improved. In addition, it can be considered that, since the ratio (Pi/Po) is not too high, the contact between the heat dissipation surface and the present filler and/or the contact between the present fillers do not become point contact(s), and the thermal contact resistance does not increase.

In Examples and Comparative Examples, boron nitride aggregate particles are adopted as the filler, and calender pressing or flat plate pressing is adopted as the pressure application method. However, in consideration of the mechanism of action of increasing the thermal conductivity of the sheet described above, it is considered that the same effect as that obtained by the boron nitride aggregate particles can be obtained as long as the filler is a filler in which primary particles have anisotropy in thermal conductivity, that is, a filler formed by aggregation of primary particles having a plate shape, a scale shape, or a needle shape. In addition, it is considered that, when the primary particles of the filler are oriented as described above in the sheet, the thermal conductivity can be increased, regardless of the manufacturing method such as calender pressing or flat plate pressing.

It has been confirmed by cross-sectional SEM that the boron nitride aggregate particles exhibiting a spherical shape by aggregation are also aggregated in a spherical shape even in the resin sheet.

## Claims

1. A resin sheet comprising a filler formed by aggregation of primary particles having a plate shape, a scale shape or a needle shape,
wherein a ratio (Pi/Po) of a peak area intensity ratio Pi ((002)/(100)) to a peak area intensity ratio Po ((002)/(100)) is 0.13 or more and 0.41 or less,
the peak area intensity ratio Pi ((002)/(100)) being a peak area intensity ratio between a (002) plane of the filler and a (100) plane of the filler in the resin sheet, the peak area intensity ratio Pi being obtained by measuring the resin sheet by an In-Plane X-ray diffraction method,
the peak area intensity ratio Po ((002)/(100)) being a peak area intensity ratio between the (002) plane of the filler and the (100) plane of the filler in the resin sheet, and the peak area intensity ratio Po being obtained by measuring the resin sheet by an X-ray diffraction method using a focusing method.

2. A resin sheet comprising a filler formed by aggregation of primary particles having a plate shape, a scale shape or a needle shape, wherein
a peak area intensity ratio Pi ((002)/(100)) between a (002) plane of the filler and a (100) plane of the filler in the resin sheet, the peak area intensity ratio Pi being obtained by measuring the resin sheet by an In-Plane X-ray diffraction method, is 1.5 or more and 10.0 or less, and
a peak area intensity ratio Po ((002)/(100)) between the (002) plane of the filler and the (100) plane of the filler in the resin sheet, the peak area intensity ratio Po being obtained by measuring the resin sheet by an X-ray diffraction method using a focusing method, is 9.0 or more and 13.0 or less.

3. The resin sheet according to claim 1, wherein the peak area intensity ratio Pi ((002)/(100)) is 1.5 or more and 10.0 or less.

4. The resin sheet according to claim 1, wherein the peak area intensity ratio Po ((002)/(100)) is 9.0 or more and 13.0 or less.

5. The resin sheet according to claim 1 or 2, wherein the resin sheet is a cured product of a thermosetting resin composition containing the filler and a thermosetting resin.

6. The resin sheet according to claim 5, wherein the thermosetting resin contains an epoxy resin.

7. The resin sheet according to claim 1 or 2, wherein the filler has a thermal conductivity of 10 W/m·k or more.

8. The resin sheet according to claim 1 or 2, wherein the filler contains boron nitride aggregate particles.

9. The resin sheet according to claim 8, wherein the boron nitride aggregate particles have a card-house structure.

10. The resin sheet according to claim 1 or 2, wherein the resin sheet has a thermal conductivity of 10 W/m·K or more in a sheet thickness direction at 25°C.

11. The resin sheet according to claim 1 or 2, wherein the resin sheet is used as a heat dissipation member of a power semiconductor device.

12. A method for manufacturing the resin sheet described in claim 1 or 2, the method comprising:
molding the thermosetting resin composition containing the filler and the thermosetting resin into a coating film form or a sheet form; applying pressure to the thermosetting resin composition; and thermally curing the thermosetting resin composition.

13. The method manufacturing the resin sheet according to claim 12, wherein the pressure application is performed by calender pressing under conditions of a linear pressure of 20 to 200 kgf/cm applied to the sheet and a roller temperature of 0 to 50°C, or by flat plate pressing under conditions of a pressure of 10 to 2000 kgf/cm² applied to the sheet, a metallic flat plate temperature of 0 to 100°C, and a pressure application time of 1 to 1500 seconds.

14. The method for manufacturing the resin sheet according to claim 12, wherein the thermal curing is performed by heating to 80 to 300°C, and pressure application at a pressure of 50 to 2000 kgf/cm² for 0.5 to 240 minutes.

15. The method for manufacturing the resin sheet according to claim 12, the method further comprising subjecting the thermosetting resin composition to low-temperature aging, the low-temperature aging including placing the thermosetting resin composition in a temperature environment of 0°C or lower.

16. The method for manufacturing the resin sheet according to claim 15, wherein the low-temperature aging is performed after the molding the thermosetting resin composition into a coating film form or a sheet form and before the applying pressure to the thermosetting resin composition.
